# EUROPÄISCHE PATENTSCHRIFT

(11) **EP 0 556 184 B1**
(45) Veröffentlichungstag und Bekanntmachung des Hinweises auf die Patenterteilung: **28.02.1996**
(21) Anmeldenummer: 91914556.5
(22) Anmeldetag: 15.08.1991
(51) Int. Cl.: H05K 1/18

(54) **LEITERPLATTE MIT ELEKTRISCHEN BAUELEMENTEN, INSBESONDERE IN SMD-AUSFÜHRUNG**
CIRCUIT BOARD WITH ELECTRICAL COMPONENTS, IN PARTICULAR SURFACE-MOUNTED DEVICES
PLAQUETTE A CIRCUITS IMPRIMES COMPORTANT DES COMPOSANT ELECTRIQUES, EN PARTICULIER EN EXECUTION CMS

(30) Priorität: 18.08.1990 DE 4026233
(43) Veröffentlichungstag der Anmeldung: 25.08.1993
(73) Patentinhaber: HILLER, Peter, D-71679 Asperg (DE)
(72) Erfinder: HILLER, Peter, D-71679 Asperg (DE)
(74) Vertreter: Vogel, Georg
(86) Internationale Anmeldenummer: DE9100648
(87) Internationale Veröffentlichungsnummer: WO9203901

(56) Entgegenhaltungen:
- DE-A- 1 514 009
- DE-A- 2 346 924
- DE-A- 3 430 849

## Beschreibung

Die Erfindung betrifft eine Leiterplatte mit elektrischen Bauelementen, bei der die Bauelemente mit ihren isolierten Baukörpern in Durchgangsbohrungen der Leiterplatte eingesetzt sind, auf der Leiterplattenunterseite und der Leiterplattenoberseite geringfügig vorstehen und in diesen Bereichen Kontaktflächen tragen, die mit Leiterbahnen der Leiterplatte verlötet sind, wobei die unteren Enden der Bauelemente als Halbkugelkalotte oder abgerundete Kegelspitze auslaufen und entsprechende untere Kontaktflächen aufweisen, welche in als Lötaugen ausgebildete Leiterbahnen der Leiterplatte ragen und mit diesen verlötet sind.

Eine derartige Leiterplatte ist z.B. aus der DE 31 15 303 A1 oder der US-PS 48 78 155 bekannt. Jedes Bauelement ist dabei als Einzelelement, wie Widerstand, Kondensator, Diode oder dgl. ausgebildet, so daß keine große Packungsdichte der Bauelemente auf der Leiterplatte erreicht werden kann.

Es ist Aufgabe der Erfindung, eine Leiterplatte der eingangs erwähnten Art zu schaffen, deren Bauelemente bei schneller und automatischer Bestückung und Verlötung eine wesentlich höhere Packungsdichte zulassen.

Diese Aufgabe wird nach der Erfindung dadurch gelöst, daß die oberen Enden der Bauelemente mehrere gegeneinander isolierte obere Kontaktflächen tragen, welche mit am Bauteilkörper abstehenden Kontaktelementen verbunden sind, die im Abstand um die Bohrungen der Leiterplatte mittels Lötpaste mit Leiterbahnen der Leiterplattenoberseite verbunden sind.

Die Bauelemente sind als Mehrfachelemente mit individuellen Kontaktelementen ausgebildet, die mit Lötpaste ohne Gefahr von Lötbrückenbildung mit den Leiterbahnen auf der Leiterplattenoberseite verbunden werden, während das untere Kontaktelement im konventionellen Lötbad mit der Leiterbahn auf der Leiterplattenunterseite verbunden wird.

Eine ausgezeichnete großflächige Verlötung der unteren Kontaktflächen der Bauelemente im Lötbad wird dadurch erhalten, daß die unteren Kontaktflächen von der Leiterplattenunterseite her teilweise in die Bohrungen der Leiterplatte hineinragen und daß die Lötaugen auf der Leiterplattenunterseite bis fast an die Bohrungen heranreichen. Das Lot wird dabei an der Kontaktfläche hochgezogen.

Damit der Abstand der oberen zentrischen Kontaktflächen auch zum Bohrungsrand vergrößert wird, sieht eine Ausgestaltung vor, daß die oberen Kontaktelemente mit der Leiterplattenoberseite einen spitzen Winkel einschließen.

Nach einer Ausgestaltung kann vorgesehen sein, daß die obere Kontaktfläche mit den Kontaktelementen kreisbogenförmige Kontaktfedern ausgebildet sein können, die sich nur über Teile des Umfanges des oberen Endes des Bauelementes erstrecken.

Ist nach einer weiteren Ausgestaltung vorgesehen, daß das obere Ende des Bauelementes im Querschnitt polygonal ausgebildet ist, die auf den Außenflächen mit individuellen Kontaktelementen versehen sind, dann kann sich das Bauelement auch über die Bohrung hinaus erstrecken und so im Aufbau wesentlich erweitert werden, und die Möglichkeit bietet, mehrere, obere Kontaktelemente anzubringen.

Die mechanische Festlegung der Bauelemente in den Bohrungen der Leiterplatte kann durch an sich bekannte Paß- und/oder Preßsitz erfolgen. Dabei können auch elastische Außenlagen des Bauelementes von Vorteil sein.

Eine weitere Möglichkeit der mechanischen Festlegung besteht darin, daß der Baukörper des Bauelementes im Bereich der Bohrung der Leiterplatte mittels umlaufender Stege abgedichtet gehalten ist.

Um die Art des eingesetzten Bauelementes auch noch an der bestückten Leiterplatte erkennen zu können, sieht eine Weiterbildung vor, daß die oberen Kontaktelemente unterschiedlich ausgestaltet sind und so die Art des Bauelementes kennzeichnen.

Die Anschlußvariationen für das Bauelement lassen sich dadurch noch erweitern, daß auch die untere Kontaktfläche und das Lötauge in mehrere, gegeneinander isolierte Kontaktstellen unterteilt sind.

Die Erfindung wird anhand von in den Zeichnungen dargestellten Ausführungsbeispielen näher erläutert. Es zeigt:
- Fig. 1: in perspektivischer Ansicht eine Ausführung eines Bauelementes mit mehreren, oberen Kontaktelementen,
- Fig. 2: in perspektivischer Ansicht ein Bauelement mit vergrößertem oberen Ende und anders ausgebildeten Kontaktelementen, und
- Fig. 3: in perspektivischer Ansicht eine andere Ausgestaltung der Bauelemente-Oberseite.

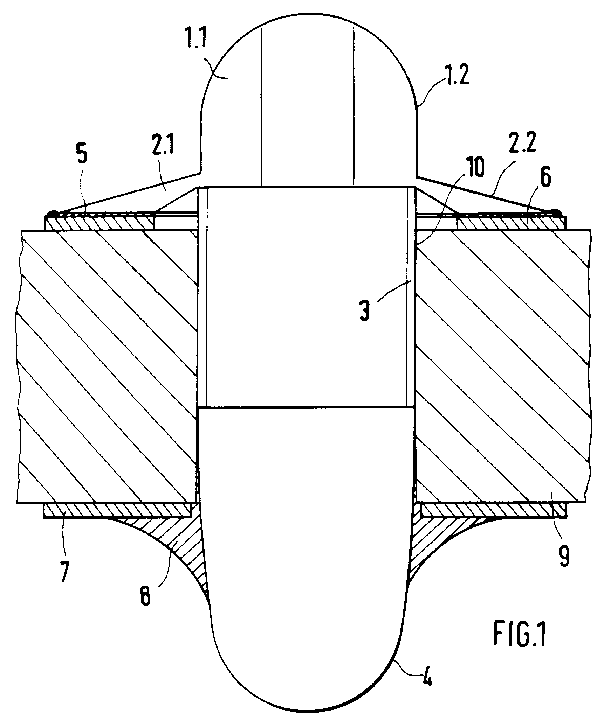

In Fig. 1 ist ein Teil der Leiterplatte 9 mit einer Bohrung 10 gezeigt. In diese Bohrung 10 wird das Bauelement mit dem Baukörper 3 eingesetzt und darin z.B. durch Paß-und/oder Preßsitz mechanisch gehalten. Das untere Ende des vorzugsweise in SMD-Ausführung hergestellten Bauelementes ist als Kugelkalotte ausgebildet, die aus dem unteren Ende der Bohrung 10 herausragt. Um diese Bohrung 10 trägt die Leiterplattenunterseite das Lötauge 7, das nahe an die Bohrung 10 heranreicht. Der Baukörper 3 isoliert die untere Kontaktfläche 4, die sich über die Halbkugelkalotte hinaus zum Teil in die Bohrung 10 hinein erstreckt. Dabei reicht die Kontaktfläche 4 erst allmählich an die Bohrung heran, um einen Anstieg des Lotes 8 beim Lötvorgang zu erzielen. An der Leiterplattenoberseite ragt das obere Ende des Bauelementes heraus und trägt die obere Kontaktfläche 1.1 und 1.2, die mit den Kontaktelementen 2.1 und 2.2 in Verbindung steht. In vorgegebenem Abstand erstreckt sich um die Bohrung die ringförmige, jedoch geteilte Leiterbahn 6, auf der Lötpaste 5 aufgebracht ist. Die Kontaktelemente 2.1 und 2.2 sind als abstehende Kontaktfedern ausgebildet, die im spitzen Winkel zu dem Baukörper 3 stehen und sich über die Lötpaste 5 elektrisch leitend auf der ringförmigen, unterteilten Leiterbahn 6 abstützen. Das Bauelement sitzt damit geschützt in der Bohrung 10 der Leiterplatte 9 und erfordert für seine elektrische Verbindung keine durchkontaktierte Bohrung und nur sehr wenig Platz um die Bohrung 10. Durch den Abstand der unterteilten Leiterbahn 6 von der Bohrung 10 wird gewährleistet, daß beim Plazieren des Bauelementes keine Lötpaste in die Bohrung gelangen kann. Das Lötauge 7 auf der Leiterplattenunterseite muß so groß sein, daß es im Lötbad selbst und auch die untere Kontaktfläche 4 mit Lot benetzt wird, wobei sich eine Hohlkehle bildet, die neben einer ausgezeichneten elektrischen Verbindung auch eine gute Befestigung für das Bauelement bringt.

Das Bauelement wird von der Leiterplattenoberseite her in die Bohrung 10 gedrückt, bis die Kontaktelemente 2.1 und 2.2 in die auf der unterteilten Leiterbahn 6 befindliche Lötpaste 5 eintauchen. Das Bauelement wird sowohl durch die Adhäsionskraft der Lötpaste 5 als auch durch die Preß- und/oder Paßkraft zwischen der Bohrung 10 und dem Bauelement fixiert und so vorläufig befestigt. Es ist daher kein Clinchen oder Kleben erforderlich. Danach kommt die Leiterplatte in den Ofen (Reflowlöten). Dies ist auch bei SMD-Bauelemente nötig. Zum Schluß wird die Leiterplattenunterseite im Lötbad (Wellenlötung) gelötet.

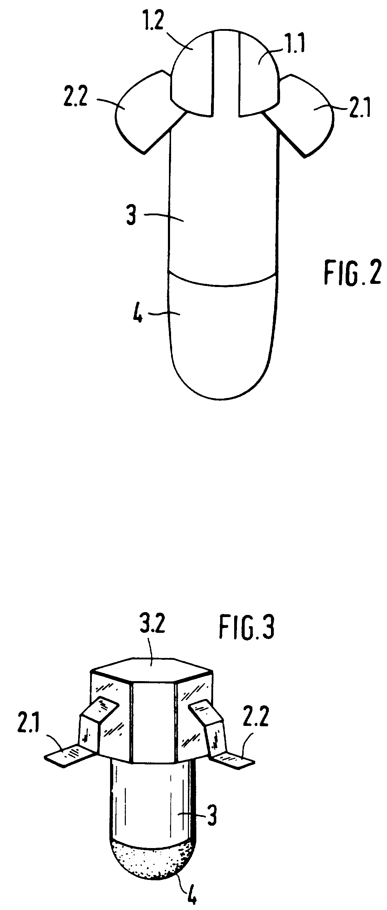

Fig. 2 zeigt das Bauelement gegenüber der Fig. 1 in verkleinertem Maßstab und läßt seine kompakte Form deutlich erkennen. Wie Fig. 2 zeigt, ist die obere Kontaktfläche in zwei gegeneinander isolierte Kontaktflächen 1.1 und 1.2 unterteilt, die dann über die Kontaktelemente 2.1 und 2.2 mit kreisbogenförmigen Teilleiterbahnen 6 verbunden werden. Die Kontaktelemente 2.1 und 2.2 reichen nur über einen Teil des Umfanges des oberen Endes des Bauelementes. Auch die untere Kontaktfläche 4 kann in mehrere, gegeneinander isolierte Teilkontaktflächen unterteilt werden. Auf diese Weise lassen sich Doppelwiderstände, Doppeldioden oder Doppelkondensatoren sowie mehrpolige Halbleiter in dem Baukörper 3 unterbringen. Es ist auch möglich, mehrpolige Schaltungen zu integrieren.

Wie Fig. 3 zeigt, kann das obere Ende des Baukörpers 3 auch einen polygonalen Kopf 3.2 aufweisen und die Bohrung 10 allseitig überdecken. Die Außenflächen des Kopfes 3.2 können alle oder abwechselnd mit Kontaktflächen und Kontaktelementen 2.1 und 2.2 versehen sein.

Es sind viele Varianten der Kopfausbildung denkbar. Und auch für die Unterteilung der Kontaktflächen ergeben sich weitere Möglichkeiten und Ausgestaltungen. Wesentlich bleibt, daß das Bauelement in der Bohrung 10 vorfixiert wird und daß die Kontaktelemente der oberen Kontaktflächen im Ofen verlötet werden können, ohne daß die Lötpaste in die Bohrung eintreten kann. Schließlich ist die Ausgestaltung der unteren Kontaktflächen so zu wählen, daß die Lötung im Lötbad gut möglich ist.

## Patentansprüche

1. Leiterplatte mit elektrischen Bauelementen, bei der die Bauelemente mit ihren isolierten Baukörpern in Durchgangsbohrungen der Leiterplatte eingesetzt sind, auf der Leiterplattenunterseite und der Leiterplattenoberseite geringfügig vorstehen und in diesen Bereichen Kontaktflächen tragen, die mit Leiterbahnen der Leiterplatte verlötet sind, wobei die unteren Enden der Bauelemente als Halbkugelkalotte oder abgerundete Kegelspitze auslaufen und entsprechende untere Kontaktflächen aufweisen, welche in als Lötaugen ausgebildete Leiterbahnen der Leiterplatte ragen und mit diesen verlötet sind,
dadurch gekennzeichnet,
daß die oberen Enden der Bauelemente mehrere gegeneinander isolierte obere Kontaktflächen (1.1, 1.2) tragen, welche mit am Bauteilkörper (3) abstehenden Kontaktelementen (2,1, 2.2) verbunden sind, und die Kontaktelemente sich im Abstand um die Bohrungen (10) der Leiterplatte (9) auf den unterteilten Leiterbahnen (6) der Leiterplattenoberseite abstützen und mittels Lötpaste mit den Leiterbahnen (6) verlötet sind.

2. Leiterplatte nach Anspruch 1,
dadurch gekennzeichnet,
daß die unteren Kontaktflächen (4) von der Leiterplattenunterseite her teilweise in die Bohrungen (10) der Leiterplatte (9) hineinragen und
daß die Lötaugen (7) auf der Leiterplattenunterseite bis fast an die Bohrungen (10) heranreichen.

3. Leiterplatte nach Anspruch 1 oder 2,
dadurch gekennzeichnet, daß die oberen Kontaktelemente (2.1, 2.2) zum Bauteilkörper (3) hin in einem spitzen Winkel stehen.

4. Leiterplatte nach einem der Ansprüche 1 bis 3,
dadurch gekennzeichnet, daß die obere Kontaktfläche mit den Kontaktelementen (2.1, 2.2) als einstückige Kontaktkappe ausgebildet ist, die auf das obere Ende des mit Kontaktflächen versehenen Bauelementes aufgesetzt ist.

5. Leiterplatte nach einem der Ansprüche 1 bis 4,
dadurch gekennzeichnet, daß die Kontaktelemente (2.1, 2.2) als kreisbogenförmige Kontaktfedern ausgebildet sind, die sich über Teile des Umfanges des oberen Endes des Bauelementes erstrecken.

6. Leiterplatte nach einem der Ansprüche 1 bis 5,
dadurch gekennzeichnet, daß das obere Ende (3.2) des Bauelementes im Querschnitt polygonal ausgebildet ist und auf den Außenflächen mit individuellen Kontaktelementen (2.1, 2.2) versehen sind.

7. Leiterplatte nach einem der Ansprüche 1 bis 6,
dadurch gekennzeichnet, daß der Baukörper (3) des Bauelementes im Bereich der Bohrung (10) der Leiterplatte (9) mittels umlaufender Stege abgedichtet gehalten ist.

8. Leiterplatte nach einem der Ansprüche 1 bis 7,
dadurch gekennzeichnet, daß die Kontaktelemente (2.1; 2.2) unterschiedlich ausgebildet sind.

9. Leiterplatte nach einem der Ansprüche 1 bis 8,
dadurch gekennzeichnet, daß auch die untere Kontaktfläche (4) und das Lötauge (7) in mehrere, gegeneinander isolierte Kontaktstellen unterteilt sind.

## Claims

1. Printed-circuit board comprising electrical components, the isolated bodies of which are fitted into through-drill-holes of the board, which components slightly extend from the bottom and top of the board and carry in that areas contact surfaces being soldered with conducting pathes of the board, the ends at the bottom of the components board running out into a hemispherical chalotte or a rounded conic top and comprising corresponding lower contact surfaces which extend into conducting pathes of the board performed as soldering eyes, and are soldered therewith, **characterized** in that the upper ends of the components carry several upper contact surfaces (1.1, 1.2) which are isolated against each other and connected with contact elements (2.1, 2.2) sticking out from the component body, and in that the contact elements are supported on the subdivided conducting pathes (6) of the top of the board in a certain distance around the drill-holes (10) of the board (9) and soldered with the conducting pathes (6) by means of a soldering grease.

2. Printed-circuit board according to claim 1, characterized in that the lower contact surfaces (4) partly extend from the bottom of the board into the drill-holes (10) of the board and that the soldering eyes (7) on the bottom of the board reach almost the drill-holes (10).

3. Printed-circuit board according to claim 1 or 2, characterized in that the upper contact elements (2.1, 2.2) stand acute-angeled towards the component body (3).

4. Printed-circuit board according to one of claims 1 to 3, characterized in that the upper contact surface together with the contact elements (2.1, 2.2) is performed as integral contact cap put on the upper end of the components provided with contact surfaces.

5. Printed-circuit board according to one of claims 1 to 4, characterized in that the contact elements (2.1, 2.2) are performed as contact springs in form of arcs, the contact springs extending over parts of the circumference of the upper end of the component.

6. Printed-circuit board according to one of claims 1 to 5, characterized in that the upper end (3.2) of the component is performed polygonally in cross-section and provided with individual contact elements (2.1, 2.2) on the outsides.

7. Printed-circuit board according to one of claims 1 to 6, characterized in that the body (3) of the component is held sealed in the area of the drill-hole (10) of the board (9) by means of circulating webs.

8. Printed-circuit board according to one of claims 1 to 7, characterized in that the contact elements (2.1, 2.2) are performed in different ways.

9. Printed-circuit board according to one of claims 1 to 8, characterized in that additionally the lower contact surface (4) and the soldering eye (7) are divided into several contact places which are isolated against each other.

## Revendications

1. Plaquette à circuits imprimés comportant des composants électriques, dans laquelle les composants électriques sont par leurs corps isolés montés dans des forures de la plaquette, font légèrement protubérance à la face inférieure et à la face supérieure de la plaquette et portent des surfaces de contact dans ces régions, qui sont soudées à des lignes conductrices de la plaquette à circuits imprimés, les extrémités inférieures des composants se terminant en calotte hémisphérique ou en pointe conique arrondie et présentant des surfaces de contact inférieures de forme correspondante qui pénètrent dans des lignes conductrices en forme d'oeillets de soudure de la plaquette et qui sont fixées par soudage à celles-ci,
caractérisée
en ce que les extrémités supérieures des composants portent plusieurs surfaces de contact (1.1, 1.2) isolées les unes des autres, qui sont reliées à des éléments de contact (2.1, 2.2) issus du composant (3), et en ce que les éléments de contact s'appuient à distance autour des forures (10) de la plaquette (9) sur les lignes conductrices subdivisées (6) de la face supérieure de la plaquette et sont au moyen de pâte à souder soudés aux lignes conductrices (6).

2. Plaquette à circuits imprimés suivant la revendication 1,
caractérisée
en ce que les surfaces de contact inférieures (4) pénètrent depuis la face inférieure de la plaquette partiellement dans les forures (10) de la plaquette à circuits imprimés (9) et en ce que les oeillets de soudure (7) sur la face inférieure de la plaquette atteignent presque les forures (10).

3. Plaquette à circuits imprimés suivant la revendication 1 ou 2,
caractérisée
en ce que les éléments de contact supérieurs (2.1, 2.2) sont disposés suivant un angle aigu par rapport au composant (3).

4. Plaquette à circuits imprimés suivant l'une quelconque des revendications de 1 à 3,
caractérisée
en ce que la surface de contact supérieure avec les éléments de contact (2.1, 2.2) à la forme d'un capuchon de contact en une pièce, qui est emmanché sur l'extrémité supérieure du composant doté de surfaces de contact.

5. Plaquette à circuits imprimés suivant l'une quelconque des revendications de 1 à 4,
caractérisée
en ce que les éléments de contact (2.1, 2.2) ont la forme de lames de contact en arc de cercle, qui s'étendent sur des parties de la périphérie de l'extrémité supérieure du composant.

6. Plaquette à circuits imprimés suivant l'une quelconque des revendications de 1 à 5,
caractérisée
en ce que l'extrémité supérieure (3.2) a une section transversale de forme polygonale et est dotée sur les surfaces extérieures d'éléments de contact individuels (2.1, 2.2).

7. Plaquette à circuits imprimés suivant l'une quelconque des revendications de 1 à 6,
caractérisée
en ce que le corps du composant (3) est dans la région de la forure (10) de la plaquette à circuits imprimés (9) maintenu de manière hermétique au moyen de languettes périphériques.

8. Plaquette à circuits imprimés suivant l'une quelconque des revendications de 1 à 7,
caractérisée
en ce que les élément de contact (2,1; 2.2) sont de formes différentes.

9. Plaquette a circuits imprimés suivant l'une quelconque des revendications de 1 à 8,
caractérisée
en ce que la surface de contact inférieure (4) et l'oeillet de soudure (7) sont eux aussi partagés en plusieurs zones de contact isolées les unes des autres.
